(19) Europäisches Patentamt European Patent Office Office européen des brevets

(11) **EP 1 394 954 B1**

(12) **EUROPEAN PATENT SPECIFICATION**

(45) Date of publication and mention
of the grant of the patent:
**23.05.2012 Bulletin 2012/21**

(51) Int Cl.:
***H04B 1/04*** *(2006.01)*

(21) Application number: **03019205.8**

(22) Date of filing: **25.08.2003**

(54) **Transmitter**

Sender

Emetteur

(84) Designated Contracting States:
**DE GB**

(30) Priority: **26.08.2002 JP 2002244754**

(43) Date of publication of application:
**03.03.2004 Bulletin 2004/10**

(73) Proprietor: **NTT DoCoMo, Inc.**
**Tokyo 100-6150 (JP)**

(72) Inventors:
• **Suzuki, Yasunori, NTT DoCoMo, Inc.**
**2-chome**
**Chiyoda-ku**
**Tokyo 100-6150 (JP)**

• **Hirota, Tetsuo, NTT DoCoMo, Inc.**
**2-chome**
**Chiyoda-ku**
**Tokyo 100-6150 (JP)**

(74) Representative: **MERH-IP**
**Matias Erny Reichl Hoffmann**
**Paul-Heyse-Strasse 29**
**80336 München (DE)**

(56) References cited:
**EP-A- 0 998 027     US-B1- 6 335 767**
**US-B1- 6 342 810**

**Description**

BACKGROUND OF THE INVENTION

Technical Field

The present invention relates to a radio base station transmitter having N transmission channels and, more particularly, to a radio base station transmitter adapted to suppress the creation of nonlinear distortions by power amplifiers.

Prior Art

A multi-port amplifier configuration has been proposed which permits reduction of the power consumption of N-channel amplifiers and implementation of their redundant configuration.

Figs. 1 and 2 show conventional multi-port amplifiers disclosed in Japanese Patent Application Laid-Open No. 10-209777.

Letting N represent an integer equal to or greater than 2, the multi-port amplifier comprises: an input side multi-port directional coupler 10 which divides and combines N input signals $x_1$, ..., $x_N$ into signals of N channels; N amplifiers $33_1$, ..., $33_N$ which amplify the output signals of the N channels by parallel operation; an output side multi-port directional coupler 40 which divides and combines the outputs from the N amplifiers to provide N output signals $u_1$, ..., $u_N$; and linearizers $20_1$, ..., $20_N$ each provided in the stage preceding one of the N amplifiers, for preimparting a compensating distortion to the signal of one of the N channels to cancel a nonlinear distortion which is created by the amplifier.

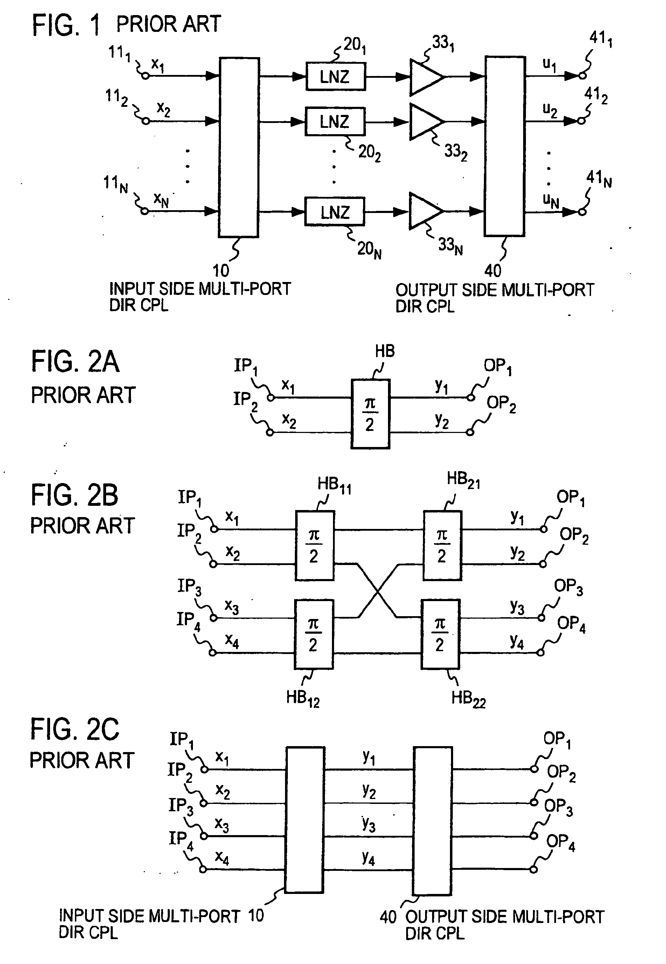

The input side digital multi-port directional coupler 10 can be formed by one or more $\pi/2$ hybrids HB each having two input ports $IP_1$, $IP_2$ and two output ports $OP_1$, $OP_2$ as shown in Fig. 2A. The relationships between two inputs $x_1$, $x_2$ and two outputs $y_1$, $y_2$ of the $\pi/2$ hybrid HB are expressed by the following equation.

$$\begin{bmatrix} y_1 \\ y_2 \end{bmatrix} = \frac{1}{\sqrt{2}} \begin{bmatrix} 1 & j \\ j & 1 \end{bmatrix} \begin{bmatrix} x_1 \\ x_2 \end{bmatrix} = \frac{1}{\sqrt{2}} \begin{bmatrix} x_1 + jx_2 \\ jx_1 + x_2 \end{bmatrix} \qquad (1)$$

where the complex number x represents a $\pi/2$ phase shift. That is, the signal $x_1$ to the first input port $IP_1$ is divided into two, one of which is output to the first output port $OP_1$ of the original channel in phase with the input signal $x_1$ and the other of which is output to the second output port $OP_2$ $\pi/2$ out of phase with the input signal $x_1$. Similarly, the input signal $x_2$ to the second input port $IP_2$ is divided into two, one of which is output to the second output port $OP_2$ of the original channel in phase with the input signal $x_2$ and the other of which is output to the second output port $OP_1$ $\pi/2$ out of phase with the input signal $x_2$. Setting a matrix $T_1$ to

$$T_1 = \frac{1}{\sqrt{2}} \begin{bmatrix} 1 & j \\ j & 1 \end{bmatrix} \qquad (2)$$

a four-port (4 inputs, 4 outputs) directional coupler can similarly be formed by four $\pi/2$ hybrids as depicted in Fig. 2B. The input and output signals can be expressed the following relationships.

$$\begin{bmatrix} y_1 \\ y_2 \\ y_3 \\ y_4 \end{bmatrix} = \frac{1}{\sqrt{2}} \begin{bmatrix} T_1 & jT_1 \\ jT_1 & T_1 \end{bmatrix} \begin{bmatrix} x_1 \\ x_2 \\ x_3 \\ x_4 \end{bmatrix} = \frac{1}{\sqrt{2}} \begin{bmatrix} 1 & j & j & -1 \\ j & 1 & -1 & j \\ j & -1 & 1 & j \\ -1 & j & j & 1 \end{bmatrix} \begin{bmatrix} x_1 \\ x_2 \\ x_3 \\ x_4 \end{bmatrix}$$

$$= \frac{1}{\sqrt{2}} \begin{bmatrix} x_1 + jx_2 + jx_3 - x_4 \\ jx_1 + x_2 - x_3 + jx_4 \\ jx_1 - x_2 + x_3 + jx_4 \\ -x_1 + jx_2 + jx_3 + x_4 \end{bmatrix} \qquad (3)$$

where the coefficient -1 of x represent the opposite phase and j the $\pi/2$ phase shift.

In general, setting $N=2^n$, an N-port directional coupler can be formed uniquely by $n2^{n-1}\pi/2$ hybrids, and its transformation matrix $T_n$ can be expressed by the following equation using $T_{n-1}$.

$$T_n = \frac{1}{\sqrt{2}} \begin{bmatrix} T_{n-1} & jT_{n-1} \\ jT_{n-1} & T_{n-1} \end{bmatrix} \qquad (4)$$

Fig. 2C shows a modified form of the four-port directional coupler, in which the multi-port directional couplers 10 and 20 are connected in cascade and the outputs $y_1$, $y_2$, $y_3$ and $y_4$ from the first-stage directional coupler 10 are input to the second-stage directional coupler 40 to obtain the original input signals $x_1$, $x_2$, $x_3$ and $x_4$. The matrix connection of the $\pi/2$ hybrid forming such a directional coupler is called Butler's matrix.

The conventional multi-port amplifier of Fig. 1, which utilizes the distribution of sending power among the transmission channels, uniformly divides or distributes the input power of each channel by the input side multi-port directional coupler 10 to the N channels. This permits reduction of the saturation output from each amplifier and reduction of the overall power consumption of the amplifiers of the N channels as compared with the power consumption in the case where amplifiers of N channels are each provided independently of the others. Furthermore, even if the amplifier of one of the N channels fails, the dividing of each input signal $x_n$ (where n=1, ..., N) by the input-side multi-port directional coupler 10 to N channels ensures power amplification by the amplifiers of the other channels. That is, it is known that the multi-port amplifier itself has a redundant configuration. Moreover, the overall efficiency of the multi-port amplifier improves through compression of the required output backoff by the linearizers $20_1$, ..., $20_N$.

The conventional multi-port amplifier of Fig. 1 has a configuration in which individual amplifiers $33_1$, ..., $33_N$ of the multi-port amplifier are linearized. Each linearizer $20_n$ is usually a predistorter since it is provided at the input side of each amplifier. In accordance with the input signal to the amplifier the predistorter linearizes its AM/AM conversion characteristic (an input amplitude-output amplitude characteristic) and AM/PM conversion characteristic (an input amplitude-output phase characteristic). The multi-port amplifier of Fig. 1 calls for the use of the predistorter which operates in the sending frequency band.

It is of prime importance to manufacture small and light-weight N-channel transmitters. In particular, an adaptive array transmitter needs to be provided with many independent transmission channels; therefore, each transmitter must be as compact as possible. Even if the Fig. 1 multi-port configuration with predistorters are used in N transmission channels, it is necessary to form the entire channel by analog circuitry. But difficulty is encountered in implementing the whole system by one digital signal processing circuit containing a modulator and to reduce the number of parts used. To afford a sufficiently high degree of isolation between the output ports of the input side digital multi-port directional coupler 10, its gain and phase deviations between channels need to be adjusted to be sufficiently smaller than predetermined values, and the manufacture of such multi-port directional couplers in large numbers requires a circuit configuration that permits simplification of such adjustments.

## SUMMARY OF THE INVENTION

The transmitter according to the present invention comprises:

an input-side digital multi-port directional coupler for dividing and combining digital transmission signals of N channels by digital processing and for outputting N-channel signals to N transmission channels, respectively;
predistorters inserted in said N transmission channels, respectively, for linearizing said N transmission channels;
transmitting parts inserted in said N transmission channels, respectively, for converting output signals from said predistorters to high-frequency signals of said N channels; and
an output-side multi-port power combiner for dividing and combining said high-frequency signals of said N-transmission channels to output high-frequency transmission signals for said N transmission channels.

## BRIEF DESCRIPTION OF THE DRAWINGS

Fig. 1 is a block diagram showing the configuration of a conventional multi-port amplifier;
Fig. 2A is a a diagram explanatory of a $\pi/2$ hybrid;
Fig. 2B is a block diagram showing the configuration of a four-port directional coupler;
Fig. 2C is a diagram explanatory of a cascade connection of directional couplers;
Fig. 3 is a block diagram illustrating a basic functional configuration of the transmitter according to the present invention;
Fig. 4 is a block diagram depicting a first embodiment of the transmitter according to the present invention;
Fig. 5 is a block diagram showing an example of the configuration of a transmitting part;
Fig. 6 is a block diagram showing an example of the configuration of a receiving part;
Fig. 7 is a block diagram depicting an example of the configuration of a predistorter;
Fig. 8 is a block diagram depicting a second embodiment of the transmitter according to the present invention; and
Fig. 9 is a block diagram depicting a third embodiment of the transmitter according to the present invention.

## DETAILED DESCRIPTION OF THE PREFERRED EMBODIMENT

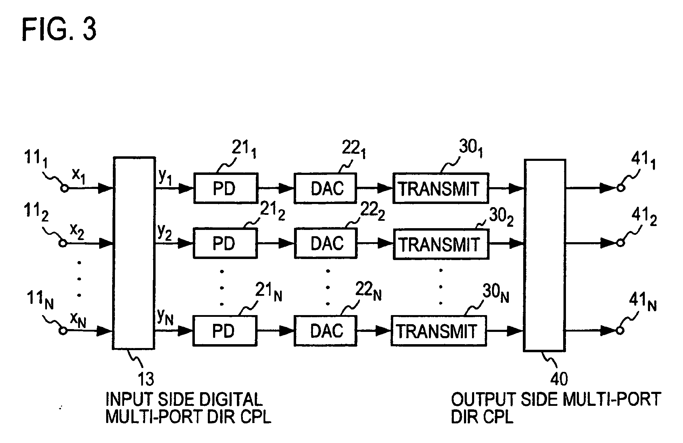

Fig. 3 illustrates a basic functional configuration of the transmitter according to the present invention. The transmitter comprises: an input side digital multi-port directional coupler 13which divides and combines input digital signals of N channels to provide output signals of N channels; predistorters $21_1$, ..., $21_N$ which impart compensating distortions to the N-channel output signals, respectively; digital-to-analog (DA) converters $22_1$, ..., $22_N$ which convert the outputs to analog signals; transmitting parts $30_1$, ..., $30_N$ which output the outputs from the DA converters as high-frequency signals; and an output side multi-port directional coupler 40 which divides and combines the outputs from the N-channel transmitting parts and sends N-channel high-frequency signals to N antennas (not shown), respectively.

As will be seen from the above, in the present invention the signal processing by the input side digital multi-port directional coupler 13 and the predistorters $21_1$, ..., $21_N$ is digital processing. By performing the function of the multi-port directional coupler 13 through digital processing, it is possible to achieve characteristics of the multi-port directional coupler with ideal gain and phase deviations.

In the following description, letting discrete time t be represented by t=mT, where T is the sample period T [sec] of a digital signal and m is a positive number, and letting the input signal $x_n(m)$ of an nth channel be represented by a complex amplitude, the input signal to the input side digital multi-port directional coupler 13 is expressed by the following matrix.

$$\mathbf{X}(m) = (x_1(m)x_2(m), \ldots, x_N(m))^{\mathbf{T}} \qquad (5)$$

where $^{T}$ represents a transposition. The input signal $\mathbf{X}(m)$ is transformed by the N-channel input side digital multi-port directional coupler 13 through use of Eq. (4) to an output signal $\mathbf{Y}(m)$ as given by the following equations.

$$\mathbf{Y}(m) = T_{\mathbf{n}}\mathbf{X}(m) \qquad (6)$$

$$Y(m) = (y_0(m)y_1(m), \ldots, y_{N-1}(m))^T \qquad (7)$$

Letting F represent a waveform transformation matrix of predistorters $21_1$, ..., $21_N$, $Y(m)$ is transformed to $Z(m)$.

$$Z(m) = F(Y(m))Y(m) \qquad (8)$$

$$Z(m) = \begin{bmatrix} f(y_0(m)) & 0 & 0 & 0 \\ 0 & f(y_1(m)) & 0 & 0 \\ 0 & 0 & \ddots & 0 \\ 0 & 0 & 0 & f(y_{N-1}(m)) \end{bmatrix} \begin{bmatrix} y_0(m) \\ y_1(m) \\ \vdots \\ y_{N-1}(m) \end{bmatrix} \qquad (9)$$

The signal $Z(m)$ is used to perform processing in the input side digital multi-port directional coupler 13 and the predistorters $21_1$, ..., $21_N$ by digital signal processing. Let $Z(t)$ represent a matrix of analog signals converted by the DA converters $22_1$, ..., $22_N$ from the signal $Z(m)$. Respective elements of the signal matrix $Z(t)$ are subjected to frequency conversion to the transmission frequency band and power amplification in the transmitting parts $30_1$, ..., $30_N$. The power-amplified signals of N channels are transformed by the output side multi-port directional coupler 40 to transmission signals $U(t)=(u_1(t), ..., u_N(t))$.

The predistorters $21_1$, ..., $21_N$ monitor the amplified output signals and adaptively update the coefficients of the waveform transformation matrix $F$ by digital processing so as to achieve predetermined nonlinear distortion characteristics.

The production of the signal $Z(m)$ by the above processing allows complete elimination of imperfection of the operating characteristic of the input side multi-port directional coupler 13 formed by analog circuitry. Further, it is possible to perform generation of the signals $X(m)$ to $Z(m)$ by digital signal processing. Since the above-described digital signal processing can be achieved by such software as DSP (Digital Signal Processor), the circuit configuration by the present invention can be implemented with more ease than the conventional configuration analog circuitry. Besides, since the input side multi-port directional coupler, which is formed by an analog circuit in the prior art, is implemented by digital signal processing, the gain and phase deviations between the output ports can be reduced to zero. Zeroing the gain and phase deviations in the analog circuit configuration is impossible in terms of circuit fabrication accuracy. Accordingly, digital signal processing permits simplification of the circuit adjustment as compared with the conventional analog circuit configuration.

**FIRST EMBODIMENT**

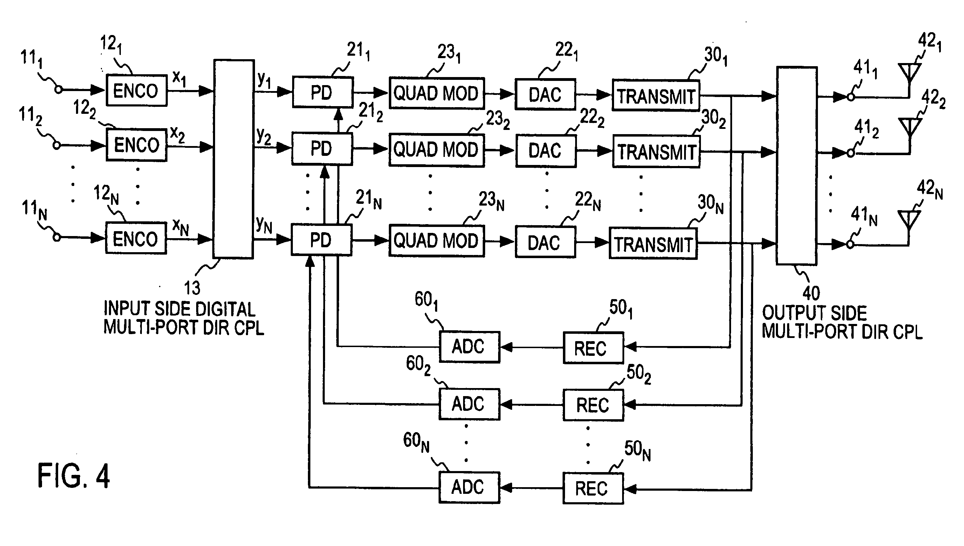

Fig. 4 illustrates the configuration of a first embodiment of the transmitter according to the present invention.

The transmitter comprises: encoders $12_1$, ..., $12_N$ of N channels; an input side digital multi-port directional coupler 13; predistorters $21_1$, ..., $21_N$; quadrature modulators $23_1$, ..., $23_N$; DA converters $22_1$, ..., $22_N$; transmitting parts $30_1$, ..., $30_N$; an output side multi-port directional coupler 40; receiving parts $50_1$, ..., $50_N$; and analog-to-digital (AD) converters $60_1$, ..., $60_N$.

The encoders $12_1$, ..., $12_N$ perform QPSK (Quadrature Phase Shift Keying) or similar encoding of a transmission digital signal sequence provided to input terminals $11_1$, ..., $11_N$.

The input side digital multi-port directional coupler 13 inputs thereto complex signals of N channels and outputs complex signals of N channels. The processing in the input digital multi-port directional coupler 13 calculates Eq. (6) through use of the matrix defined by Eqs. (4) and (5). That is, the input side digital multi-port directional coupler 13 performs processing which multiplies the input signal matrix by the transformation matrix $T_n$ starting at the left-hand side. The complex output signals of the respective channels $y_1$, ..., $y_N$ from the input side digital multi-port directional coupler 13 are fed to the predistorters $21_1$, ..., $21_N$, respectively.

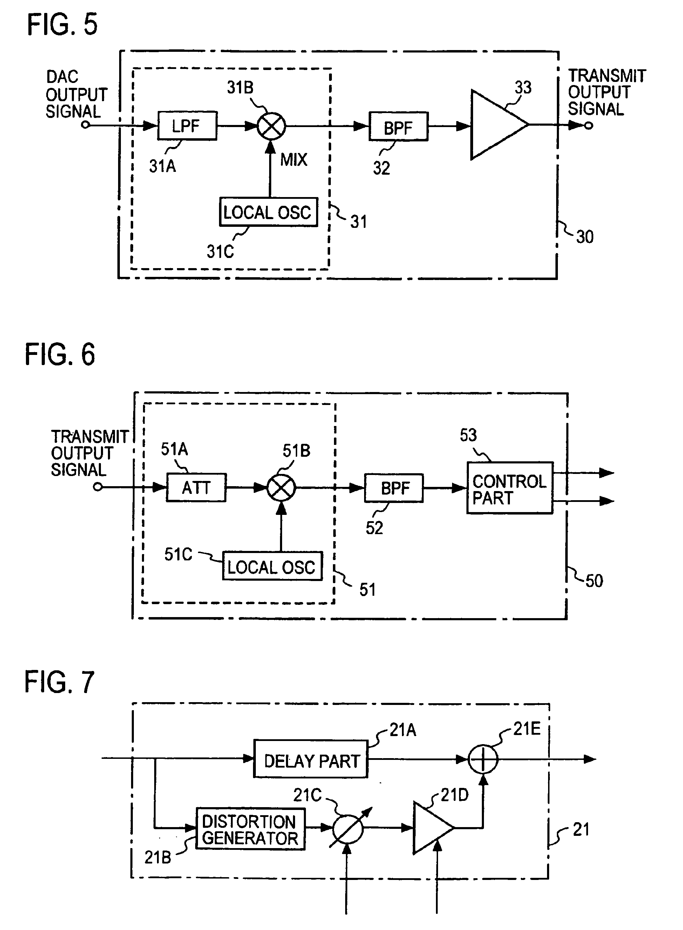

Each predistorter $21_n$ (where n=1, ..., N) linearizes gain and phase characteristics of the signal of the corresponding channel by preimparting thereto a compensating distortion which cancels the nonlinear distortion generated by a power amplifier (Fig. 5, described later on) in the transmitting part $30_n$. The configuration of the predistorter $21_n$ is a conventional look up table type or cuber distortion compensating type based on a power series model. The output signal from each predistorter $21_n$ is subjected to quadrature modulation by digital signal processing in the quadrature modulator $23_n$. The output signal from the quadrature modulator $23_n$ is converted by the DA converter $22_n$ to an analog signal, which is provided to the transmitting part $30_n$.

For example, as identified generally by 30 in Fig. 5, each transmitting part $30_n$ comprises: a frequency up-converting part 31 made up of a band-limiting low-pass filter 31A, a mixer 31B and a local oscillator 31C; a band-pass filter 32; and a power amplifier 33. In the transmitting part 30 the AD converter output signal is up-converted by being mixed with a high-frequency (RF) carrier signal generated by the local oscillator 31C, and a signal of the RF transmission frequency band is extracted by the band-pass filter 32 and subjected to power amplification by the power amplifier 33. The power-amplified high-frequency transmission signal is transmitted via an antenna $42_n$. For example, as identified generally by 50 in Fig. 6, each receiving part $50_n$ comprises: a detecting part 51 made up of an attenuator 51A, a mixer 51B and a local oscillator 51C; a band-pass filter 52; and a control part 53.

As depicted in Fig. 6, in each receiving part $50_n$ a portion of the power of the output signal from the transmitting part $30_n$ of the corresponding channel is detected by the mixer 51B and the local oscillator 51C via the attenuator 51A, and the detected signal is applied to the band-pass filter 52 to extract the distortion component generated by the power amplifier 33. Based on the extracted distortion component, the control part 53 generates a correcting signal, which is provided to the AD converter $61_n$ (Fig. 4). The correcting signal converted by the AC converter $61_n$ to digital form is applied to the predistorter $21_n$ to adjust its gain and phase characteristics to minimize the above-mentioned extracted distortion component, providing predetermined linearity of the transmitting part $30_n$.

Fig. 7 illustrates in block form an example of the predistorter $21_n$ (identified by 21). A wide variety of predistorters have already been proposed; the predistorter of this example is a digital predistorter using a power series model. The illustrated predistorter is configured to add together signals from a delay path which passes therethrough the fundamental wave component of the transmission signal, and on a path for generating an odd-order distortion based on power series. That is, the predistorter 21 of this example is made up of a delay part 21A, a distortion generator 21B, a phase adjuster 21C, a gain adjuster 21D and an adder 21E. The fundamental wave component of the transmission signal is fed to the adder 21E via the delay part 21A wherein it is delayed by the same time interval as the delay time of the distortion generating path. The distortion generator 21B generates a power series-based odd-order distortion, for example, third-order distortion, of the transmission signal. This odd-order distortion is adjusted in phase by the phase adjuster 21C and then adjusted in gain by the gain adjuster 21D, thereafter being added to the fundamental wave component by the adder 21E. The adder output is provided as the output from the predistorter 21 to the transmitting part $30_n$ via quadrature modulator $23_n$ and the DA converter $22_n$ of the corresponding channel. Incidentally, the distortion generator may configured to generate the third-, fifth-, or seventh-order distortion, or a desired combination of them.

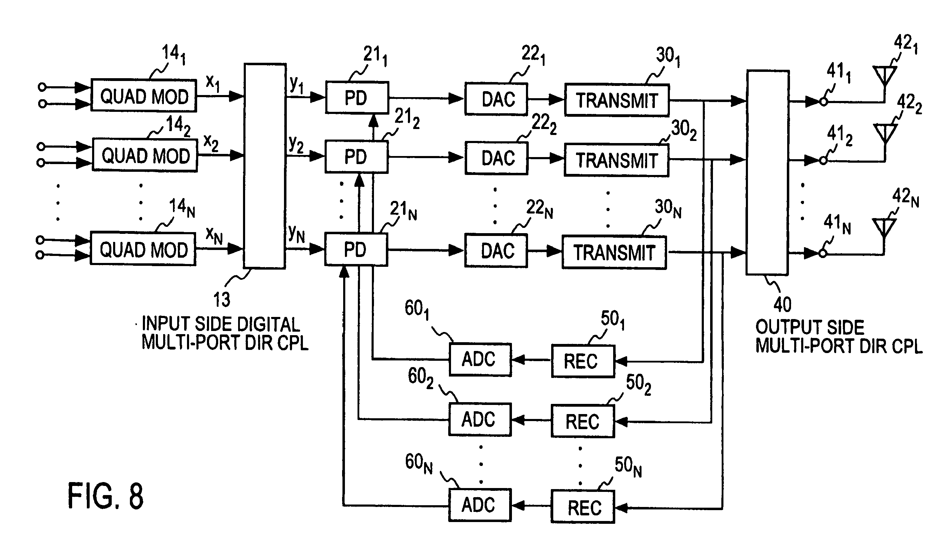

By the phase and gain correcting signals provided thereto via the AD converter $60_n$ (Fig. 4) from the control part 53 of the receiving part 50, the phase adjuster 21C an the gain adjuster 21D are adjusted to adjust the phase and gain of the odd-order distortion. The correcting signals provide coefficients for adjusting the phase adjuster 21C and the gain adjuster 21D, and define the waveform transformation matrix **F** of the predistorter in Eqs. (8) and (9). The control part 53 may also be implemented by digital signal processing. In such an instance, each AD converter $60_n$ in Figs. 4 and 8 is inserted between the band-pass filter 52 and the control part 53 in the receiving part $50_n$ of Fig. 6 to convert the distortion component extracted by the band-pass filter 52 to a digital signal, and the control part 53 generates a digital correcting signal based on the digital distortion component.

In the Fig. 4 embodiment the encoders $12_1$, ..., $12_N$ to the quadrature modulators $23_1$, ..., $23_N$ are implemented by integrated digital signal processing. For example, in the case of a digital signal processing system which operates in real time, the functions of the encoders $12_1$, ..., $12_N$ to the quadrature modulators $23_1$, ..., $23_N$ can be implemented as software. It is also possible to implement the functions of the encoders $12_1$, ..., $12_N$ to the quadrature modulators $23_1$, ..., $23_N$ by use of such hardware logic as FPGA (Field Programmable Gate Array). This embodiment permits programmable implementation of the functions of the encoders $12_1$, ..., $12_N$ to the quadrature modulators $12_1$, ..., $23_N$, and allows resetting of their functions adaptively or according to the circumstances. Accordingly, it is possible to cope with a plurality of modulation schemes and a plurality of predistortion schemes by use of the same DSP or FPGA hardware configuration. The input side digital multi-port directional coupler 13 and the predistorters $21_1$, ..., $21_N$ may also be implemented by independent control programs. Besides, the control programs for the input side multi-port directional coupler 13 and the predistorters $21_1$, ..., $21_N$ may be implemented by a single controller.

In the conventional multi-port amplifier configuration the input side digital multi-port directional coupler 13 and the output side multi-port directional coupler 40 are both implemented by analog circuits. The present invention implements the input side digital multi-port directional coupler 13 by digital signal processing as expressed by Eqs. (5) and (6). This eliminates the need for adjusting the gain and phase deviations between respective channels to be smaller than design values so as to provide a predetermined or greater degree of isolation between the output ports of the input side multi-port directional coupler as required in the prior art. That is, the present invention ensures complete isolation between the output ports of the input side directional coupler without any adjustment and hence enables the gain and phase deviations to be made zero. Accordingly, the present invention needs only adjustment of the output side multi-port directional coupler and provides an increased degree of isolation of the multi-port configuration by less adjustment than in the prior art.

**SECOND EMBODIMENT**

Fig. 8 illustrates in block form a second embodiment of the transmitter according to the present invention.
The illustrated transmitter comprises: quadrature modulators $14_1$, ..., $14_N$ for quadrature modulation of input digital IQ signals; an input side digital multi-port directional coupler 13; predistorters $21_1$, ..., $21_N$; DA converters $22_1$, ..., $22_N$; transmitting parts $30_1$, ..., $30_N$; an output side multi-port directional coupler 40; receiving parts $50_1$, ..., $50_N$; and AD converters $60_1$, ..., $60_N$. Each transmitting part $30_N$ has the afore-mentioned configuration of Fig. 5, each receiving part $50_N$ has the afore-mentioned configuration of Fig. 6, and each predistorter $21_N$ has the afore-mentioned configuration of Fig. 7. This embodiment is identical in construction with the Fig. 4 embodiment except the above.
This embodiment differs from the first embodiment in that the input digital multi-port directional coupler 13 and the predistorters $21_1$, ..., $21_N$ perform processing of the digital signals $x_1$, ..., $x_N$ subjected to quadrature modulation by the quadrature modulators $14_1$, ..., $14_N$. This embodiment is identical in operation and effect with the first embodiment. The configurations of the first and second embodiments implement the input side digital multi-port directional coupler 13 and the predistorters $21_1$, ..., $21_N$ through digital signal processing, thereby permitting simplification, miniaturization and weight reduction of the device configuration as compared with the conventional multi-port configuration.

**THIRD EMBODIMENT**

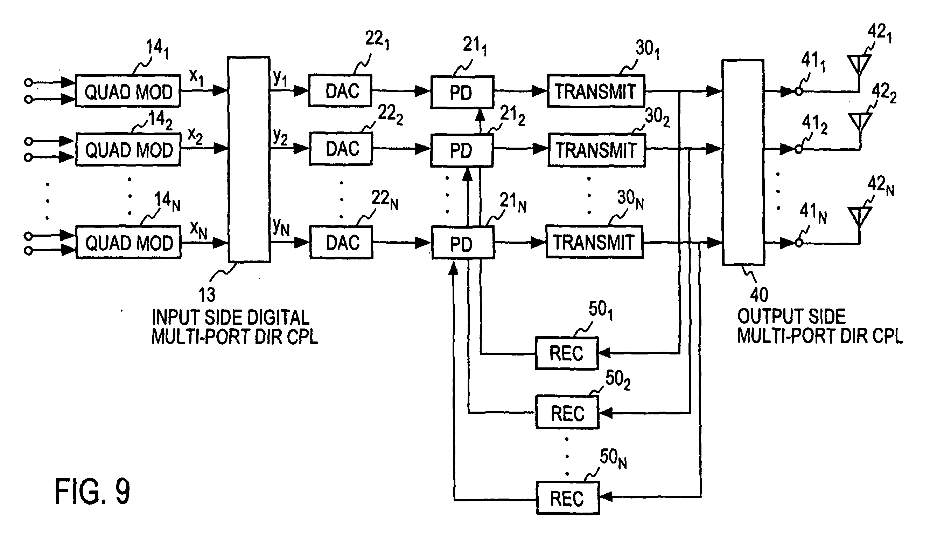

Fig. 9 illustrates in block form of the Fig. 8 embodiment. While the first and second embodiments have been described to implement the predistorters $21_1$, ..., $21_N$ by digital signal processing, they may also be formed by analog circuits as depicted in Fig. 9. In this case, the predistorters $21_1$, ..., $21_N$ are inserted between the DA converters $22_1$, ..., $22_N$ and the transmitting parts $30_1$, ..., $30_N$, respectively, and the distortion components extracted in the receiving parts $50_1$, ..., $50_N$ are applied as correcting signals in analog form to the predistorters $21_1$, ..., $21_N$, respectively. In this embodiment, since the predistorters $21_1$, ..., $21_N$ are formed by analog circuits, the transmitter configuration becomes larger than in the case of the Fig. 8 embodiment, but digital processing in the input side digital multi-port directional coupler 13 produces the intended effect.
In the first, second and third embodiments adaptive array antenna or sector antenna can be used as each of the antennas $42_1$, ..., $42_N$ which are supplied with the output from the output side multi-port directional coupler 40. Further, a duplexer or switch commonly used in radio stations may also be provided between the output side multi-port directional coupler 40 and each of the antennas $42_1$, ..., $42_N$ so that a receiver (not shown) is used also as an antenna.

EFFECT OF THE INVENTION

As described above, according to the present invention, the implementation of the input-side multi-port directional coupler and the predistorters by digital signal processing produces such effects as (1) miniaturization of the transmitter and (2) facilitation of adjustment of the multi-port configuration.

**Claims**

1. A transmitter comprising:

   an input-side multi-port directional coupler (13) for dividing and combining transmission signals of N channels and for outputting N channel signals to N transmission channels, respectively;
   predistorters ($21_1$-$21_N$) inserted in said N transmission channels, respectively, for linearizing said N transmission channels;
   transmitting parts ($30_1$-$30_N$) inserted in said N transmission channels, respectively, for converting output signals from said predistorters ($21_1$-$21_N$) to high-frequency signals of said N channels; and
   an output-side multi-port power combiner (40) for dividing and combining said high-frequency signals of said N-transmission channels to output high-frequency transmission signals for said N transmission channels

   **characterized in that**
   said input-side multi-port directional coupler (13) is a digital multi-port directional coupler for dividing and combining digital transmission signals of N channels by digital processing.

2. The transmitter of claim 1, which further comprises receiving parts ($50_1$-$50_N$) of said N channels for extracting distortion components from said high-frequency signals of N channels and for generating, based on said distortion components, compensating signals which control said linearization by said predistorters ($21_1$-$21_N$) of N channels, and wherein, based on said compensating signals, said predistorters ($21_1$-$21_N$) of N channels generate compensating distortions for canceling nonlinear distortions by said N transmission channels and impart said compensating distortions to signals of N channels, respectively.

3. The transmitter of claim 2, wherein said predistorters ($21_1$-$21_N$) of N channels are digital predistorters ($21_1$-$21_N$) of N channels for imparting said compensating distortions to said signals of N channel by digital processing, and which further comprises: digital-to-analog converters ($22_1$-$22_N$) of N channels for converting the outputs from said predistorters ($21_1$-$21_N$) of N channels to analog signals of N channels and for applying said analog signals of N channels to said transmitting parts ($30_1$-$30_N$) of N channels, respectively; and analog-to-digital converters ($60_1$-$60_N$) of N channels for converting said compensating signals from said receiving parts ($50_1$-$50_N$) of N channels to digital compensating signals and for applying said digital compensating signals to said digital predistorters ($21_1$-$21_N$) of N channels.

4. The transmitter of claim 2, wherein said predistorters ($21_1$-$21_N$) of N channels are analog predistorters ($21_1$-$21_N$), and which further comprises digital-to-analog converters ($22_1$-$22_N$) of N channels for converting said signals of N channels output from said input side digital multi-port directional coupler (13) to analog signals for application to said analog predistorters ($21_1$-$21_N$) of N channels, said receiving parts ($50_1$-$50_N$) of N channels providing said compensating signals to said digital predistorters ($21_1$-$21_N$).

5. The transmitter of claim 3 or 4, wherein each of said transmitting parts ($30_1$-$30_N$) of N channels includes: an up-converting part (31) for up-converting the corresponding one of said signals of N channels to a high-frequency signal of the transmission frequency band; and a power amplifier (33) for amplifying the power of said high-frequency signal and for applying said power-amplified high-frequency signal to said output side multi-port directional coupler (13).

6. The transmitter of claim 3 or 4, wherein each of said receiving parts ($50_1$-$50_N$) of N channels includes: a detecting part (51) for detecting the corresponding one of said high-frequency signals of N channels; a band-pass filter (52) for extracting a distortion component by said power amplifier from said detected output; and a control part (53) for generating said compensating signal based on said distortion component.

**Patentansprüche**

1. Sender, der aufweist:

   einen eingangsseitigen Mehrfachanschluss-Richtungskoppler (13) zum Teilen und Kombinieren von Sendesignalen von N Kanälen und zum Ausgeben von N Kanal-Signalen jeweils an N Übertragungskanäle;
   Vorverzerrer ($21_1$- $21_N$), die jeweils in die N Übertragungskanäle eingefügt sind, zum Linearisieren der N Übertragungskanäle;
   sendende Teile ($30_1$- $30_N$), die jeweils in die N Übertragungskanälen eingefügt sind, zum Umwandeln von Ausgabesignalen von den Vorverzerrern ($21_1$- $21_N$) in Hochfrequenzsignale der N Kanäle; und
   einen ausgangsseitigen Mehrfachanschluss-Leistungskombinierer (40) zum Teilen und Kombinieren der Hochfrequenzsignale der N-Übertragungskanäle, um Hochfrequenz-Sendesignale für die N Übertragungskanäle auszugeben,

   **dadurch gekennzeichnet, dass**
   der eingangsseitige Mehrfachanschluss-Richtungskoppler (13) ein digitaler Mehrfachanschluss-Richtungskoppler ist zum Teilen und Kombinieren von digitalen Sendesignalen von N Kanälen durch digitale Verarbeitung.

2. Sender gemäß Anspruch 1, der weiter aufweist empfangende Teile ($50_1$ - $50_N$) der N Kanäle zum Extrahieren von Verzerrungskomponenten aus den Hochfrequenzsignalen von N Kanälen und zum Erzeugen, basierend auf den Verzerrungskomponenten, von Kompensationssignalen, die die Linearisierung durch die Vorverzerrer ($21_1$- $21_N$) von N Kanälen steuern, und wobei, basierend auf den Kompensationssignalen, die Vorverzerrer ($21_1$-$21_N$) von N Kanälen Kompensierungsverzerrungen erzeugen zum Aufheben nichtlinearer Verzerrungen durch die N Übertragungskanäle und die Kompensierungsverzerrungen jeweils an Signale von N Kanälen weitergeben.

3. Sender gemäß Anspruch 2, wobei die Vorverzerrer ($21_1$- $21_N$) von N Kanälen digitale Vorverzerrer ($21_1$- $21_N$) von N Kanälen sind zum Weitergeben der Kompensierungsverzerrungen an die Signale von N Kanälen durch digitale Verarbeitung, und der weiter aufweist: Digital-Analog-Wandler ($22_1$-$22_N$) von N Kanälen zum Umwandeln der Ausgaben von den Vorverzerrern ($21_1$- $21_N$) von N Kanälen in analoge Signale von N Kanälen und zum Anwenden der analogen Signale von N Kanälen jeweils auf die sendenden Teile ($30_1$- $30_N$) von N Kanälen; und Analog-Digital-Wandler ($60_1$- $60_N$) von N Kanälen zum Umwandeln der Kompensationssignale von den empfangenden Teilen ($50_1$- $50_N$) von N Kanälen in digitale Kompensationssignale und zum Anwenden der digitalen Kompensationssignale auf die digitalen Vorverzerrer ($21_1$ - $21_N$) von N Kanälen.

4. Sender gemäß Anspruch 2, wobei die Vorverzerrer ($21_1$- $21_N$) von N Kanälen analoge Vorverzerrer ($21_1$ - $21_N$) sind, und der weiter Digital-Analog-Wandler ($22_1$- $22_N$) von N Kanälen aufweist zum Umwandeln der Signale von N Kanälen, ausgegeben von dem eingangsseitigen Mehrfachanschluss-Richtungskoppler (13), in analoge Signale zur Anwendung auf die analogen Vorverzerrer ($21_1$- $21_N$) von N Kanälen, wobei die empfangenden Teile ($50_1$ - $50_N$) von N Kanälen die Kompensationssignale an die digitalen Vorverzerrer ($21_1$- $21_N$) liefern.

5. Sender gemäß Anspruch 3 oder 4, wobei jedes der sendenden Teile ($30_1$ - $30_N$) von N Kanälen umfasst: einen Aufwärtswandlungs-Teil (31) zum Aufwärtswandeln des entsprechenden der Signale von N Kanälen zu einem Hochfrequenzsignal des Übertragungsfrequenzbands; und einen Leistungsverstärker (33) zum Verstärken der Leistung des Hochfrequenzsignals und zum Anwenden des leistungsverstärkten Hochfrequenzsignals auf den ausgangsseitigen Mehrfachanschluss-Richtungskoppler (13).

6. Sender gemäß Anspruch 3 oder 4, wobei jedes der empfangenden Teile ($50_1$- $50_N$) von N Kanälen umfasst: einen Erfassungsteil (51) zum Erfassen des entsprechenden der Hochfrequenzsignale von N Kanälen; einen Bandpassfilter (52) zum Extrahieren einer Verzerrungskomponente durch den Leistungsverstärker aus der erfassten Ausgabe; und einen Steuerungsteil (53) zum Erzeugen des Kompensationssignals basierend auf der Verzerrungskomponente.

## Revendications

1. Émetteur comprenant :

   un coupleur directif multiport (13) de côté entrée destiné à séparer et à combiner des signaux d'émission de N voies et à sortir N signaux de voie vers N voies d'émission, respectivement ;
   des dispositifs de prédistorsion ($21_1$ à $21_N$) insérés dans lesdites N voies d'émission, respectivement, pour linéariser lesdites N voies d'émission ;
   des modules ($30_1$ à $30_N$) d'émission insérés dans lesdites N voies d'émission, respectivement, pour convertir des signaux de sortie desdits dispositifs de prédistorsion ($21_1$ à $21_N$) en signaux à haute fréquence desdites N voies ; et
   un combineur multiport (40) de puissance de côté sortie destiné à séparer et à combiner lesdits signaux à haute fréquence desdites N voies d'émission pour sortir des signaux d'émission à haute fréquence pour lesdites N voies d'émission,

   **caractérisé en ce que** ledit coupleur directif multiport (13) de côté entrée est un coupleur directif multiport numérique destiné à séparer et à combiner, par traitement numérique, des signaux numériques d'émission de N voies.

2. Émetteur selon la revendication 1, qui comprend en outre des modules ($50_1$ à $50_N$) de réception desdites N voies pour extraire des composantes de distorsion desdits signaux à haute fréquence de N voies et pour engendrer, en se basant sur lesdites composantes de distorsion, des signaux de compensation qui commandent ladite linéarisation par lesdits dispositifs de prédistorsion ($21_1$ à $21_N$) des N voies, et dans lequel, en se basant sur lesdits signaux de compensation, lesdits dispositifs de prédistorsion ($21_1$ à $21_N$) des N voies engendrent des distorsions de compensation destinées à annuler des distorsions non linéaires produites par lesdites N voies d'émission et imposent lesdites distorsions de compensation aux signaux des N voies, respectivement.

3. Émetteur selon la revendication 2, dans lequel lesdits dispositifs de prédistorsion ($21_1$ à $21_N$) des N voies sont des dispositifs numériques ($21_1$ à $21_N$) de prédistorsion de N voies destinés à imposer, par traitement numérique, lesdites distorsions de compensation auxdits signaux des N voies, et qui comprend en outre des convertisseurs de numérique en analogique ($22_1$ à $22_N$) de N voies destinés à convertir les sorties desdits dispositifs de prédistorsion ($21_1$ à $21_N$) des N voies en signaux analogiques de N voies et à appliquer lesdits signaux analogiques de N voies auxdits

modules ($30_1$ à $30_N$) d'émission des N voies, respectivement ; et des convertisseurs d'analogique en numérique ($60_1$ à $60_N$) de N voies destinés à convertir lesdits signaux de compensation provenant desdits modules ($50_1$ à $50_N$) de réception des N voies en signaux numériques de compensation pour appliquer lesdits signaux numériques de compensation auxdits dispositifs numériques ($21_1$ à $21_N$) de prédistorsion des N voies.

4. Émetteur selon la revendication 2, dans lequel lesdits dispositifs ($21_1$ à $21_N$) de prédistorsion des N voies sont des dispositifs analogiques ($21_1$ à $21_N$) de prédistorsion, et qui comprend en outre des convertisseurs de numérique en analogique ($22_1$ à $22_N$) de N voies destinés à convertir lesdits signaux des N voies sortis dudit coupleur directif multiport (13) de côté entrée en signaux analogiques pour application auxdits dispositifs analogiques ($21_1$ à $21_N$) de prédistorsion des N voies, lesdits modules ($50_1$ à $50_N$) de réception des N voies fournissant lesdits signaux de compensation auxdits dispositifs numériques ($21_1$ à $21_N$) de prédistorsion.

5. Émetteur selon la revendication 3 ou 4, dans lequel chacun desdits modules ($30_1$ à $30_N$) d'émission des N voies inclut : un module (31) de transposition de fréquence destiné à transposer en fréquence ceux qui correspondent desdits signaux des N voies en un signal à haute fréquence de la bande de fréquences d'émission ; et un amplificateur (33) de puissance destiné à amplifier la puissance dudit signal à haute fréquence et à appliquer ledit signal à haute fréquence amplifié en puissance audit coupleur directif multiport (13) de côté sortie.

6. Émetteur selon la revendication 3 ou 4, dans lequel chacun desdits modules ($50_1$ à $50_N$) de réception des N voies inclut : un module (51) de détection destiné à détecter ceux qui correspondent desdits signaux à haute fréquence des N voies ; un filtre passe-bande (52) destiné à extraire, de ladite sortie détectée, une composante de distorsion produite par ledit amplificateur de puissance ; et un module (53) de commande destiné à engendrer ledit signal de compensation en se basant sur ladite composante de distorsion.

FIG. 1 PRIOR ART

INPUT SIDE MULTI-PORT
DIR CPL

OUTPUT SIDE MULTI-PORT
DIR CPL

FIG. 2A
PRIOR ART

FIG. 2B
PRIOR ART

FIG. 2C
PRIOR ART

INPUT SIDE MULTI-PORT 10
DIR CPL

40 OUTPUT SIDE MULTI-PORT
DIR CPL

11

## FIG. 3

INPUT SIDE DIGITAL
MULTI-PORT DIR CPL

OUTPUT SIDE MULTI-PORT
DIR CPL

FIG. 4

FIG. 5

DAC
OUTPUT
SIGNAL

LPF — 31A

31B — MIX

LOCAL OSC — 31C

31

BPF — 32

33

TRANSMIT
OUTPUT
SIGNAL

30

FIG. 6

TRANSMIT
OUTPUT
SIGNAL

ATT — 51A

51B

51C — LOCAL OSC

51

BPF — 52

CONTROL
PART — 53

50

FIG. 7

DELAY PART — 21A

21E

DISTORTION
GENERATOR — 21B

21C

21D

21

FIG. 8

FIG. 9

**EP 1 394 954 B1**

**REFERENCES CITED IN THE DESCRIPTION**

**Patent documents cited in the description**

- JP 10209777 A